# EUROPEAN PATENT SPECIFICATION

(11) **EP 0 608 664 B1**
(45) Date of publication and mention of the grant of the patent: **06.05.1999**
(21) Application number: 93830031.6
(22) Date of filing: 29.01.1993
(51) Int. Cl.: H03H 1/00, H03H 17/02

(54) **Method of filtering high resolution digital signals and corresponding architecture of digital filter**
Verfahren zur Filterung digitaler Signale mit hoher Auslösung und entsprechendem Aufbau digitaler Filter
Méthode pour filtrer des signaux numériques à haute résolution et architecture correspondante d'un filtre numérique

(43) Date of publication of application: 03.08.1994
(73) Proprietor: STMicroelectronics S.r.l., 20041 Agrate Brianza (Milano) (IT)
(72) Inventor: Golla, Carla, I-20099 Sesto San Giovanni (MIlano) (IT); Cremonesi, Alessandro, I-20079 S. Angelo Lodigiano (Milano) (IT)
(74) Representative: Botti, Mario

(56) References cited:
- EP-A- 0 494 696
- WO-A-92/11696
- PATENT ABSTRACTS OF JAPAN vol. 16, no. 67 (E-1168)19 February 1992
- PATENT ABSTRACTS OF JAPAN vol. 9, no. 16 (P-329)23 January 1985

## Description

### Field of Application

This invention relates to a method of filtering digital signals having high dynamic ranges to a narrower band of their sampling frequency.

The invention also concerns a digital filter architecture as obtained by said method.

The field of application of the invention is particularly, though not exclusively, related to digital filters of the non-recursive linear phase type, also known as FIR (Finite Impulse Response) filters, and the description herein below will make reference to that field of application merely for convenience of illustration

### Background Art

As is well known, digital filters are devices which convert an input sampled signal into another sampled, output signal having predetermined frequency response characteristics.

A sampled signal is understood to mean a digital coding comprising a predetermined number N of bits which determines the accuracy or resolution of the filter.

Digital filters are used primarily in digital oscilloscopes, spectrum analyzers, and audio and video signal processors.

Furthermore, the use of such filters is an ever expanding one, on account of the many advantages that they afford over corresponding analog filters.

For the same function, in fact, digital filters allow to achieve very narrow transmission bands and are also stabler, both over time and facing variations in power supply and operating temperature.

It is current practice to implement digital filters in the integrated circuit form using digital multipliers and adders.

Digital multipliers may be arranged to include a non-volatile memory structure of the so-called "look-up table" type, whereinto the products of the input sample signals by the filter transfer function coefficients are stored.

Such a structure is described, for example, in an article "30-MSamples/s Programmable Filter Processor", IEEE Journal of Solid-State Circuits, Vol. 25, No. 6, December 1990, and in Italian Patent Application No. 22954-A/88 by this Applicant.

While being in many ways advantageous, that prior approach still has the drawback discussed herein below.

If n is the number of bits used to sample the input signal, N the overall number of the filter coefficients, and p the number of bits required for storing the product of the samples and the coefficients, then the memory size is found to be 2nNp.

It is clear from the above that to increase, even by a single bit, the sampled description of the input signal in order to increase the filter resolution, is to double the size of the memory.

The prior art has failed to bring forth any useful solution to obviate the need for so great a memory expansion when improved filter accuracy or resolution is sought.

A known solution is disclosed in the Japanese patent application No. JP-A-32 61 213 which relates to a digital filter circuit applying parallel processing to a sampled input digital signal.

This document teaches to divide the input signal into two signal series by a switching circuit 2 which is used at the beginning of the filtering operation.

The underlying technical problem of this invention is to provide a filtering method and a digital filter for use therewith, having respectively such functional and structural features as to enable high-resolution processing of digital sampled signals, thereby overcoming the limitations of state-of-art approaches.

### Summary of the Invention

The invention is defined by the appended claims.

The idea at the base of the present invention is that of filtering the input signal using at least two filtering modes (i.e. at least two types of transfer functions), and then reconstituting the two different digital outputs generated by each filtering arrangement, using an adder circuit.

Basing on this idea, the technical problem is solved by a filtering method as indicated above and defined in the characterizing portion of Claim 1.

The technical problem is also solved by a digital filter architecture as defined in Claim 5.

The features and advantages of the inventive method will become more clearly apparent from the following detailed description of an exemplary, non-limitative embodiment thereof, given with reference to a digital filter architecture illustrated in the accompanying drawings.

### Brief Description of the Drawings

- Figure 1 is a block diagram which illustrates a method of filtering digital signals according to the prior art.

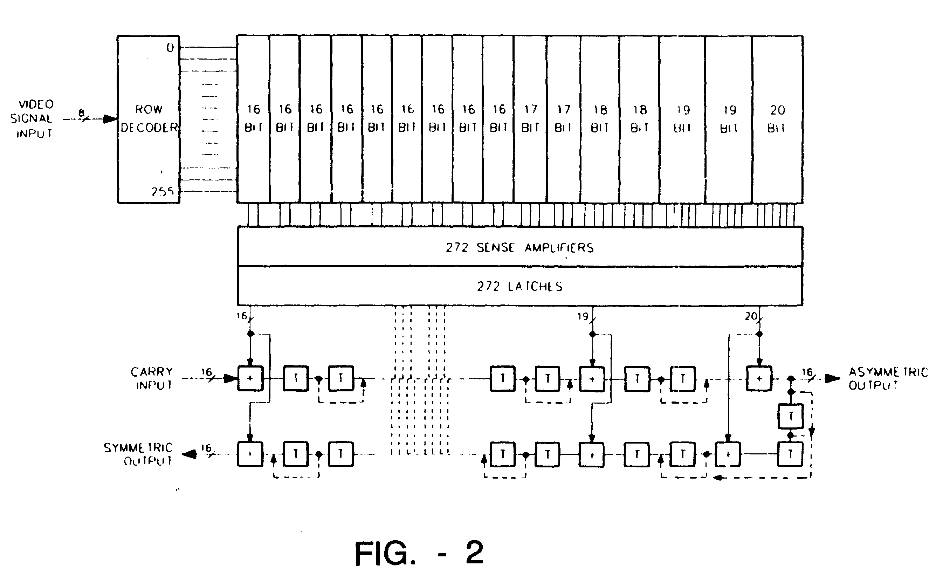

- Figure 2 shows a digital (PFP) filter in diagramatic form.
- Figure 3 shows the response of the filter in Figure 2, for a first transfer function.
- Figure 4 shows the response of the filter in Figure 2, for a second transfer function.
- Figure 5 is a diagramatic representation of a digital filter architecture embodying this invention.

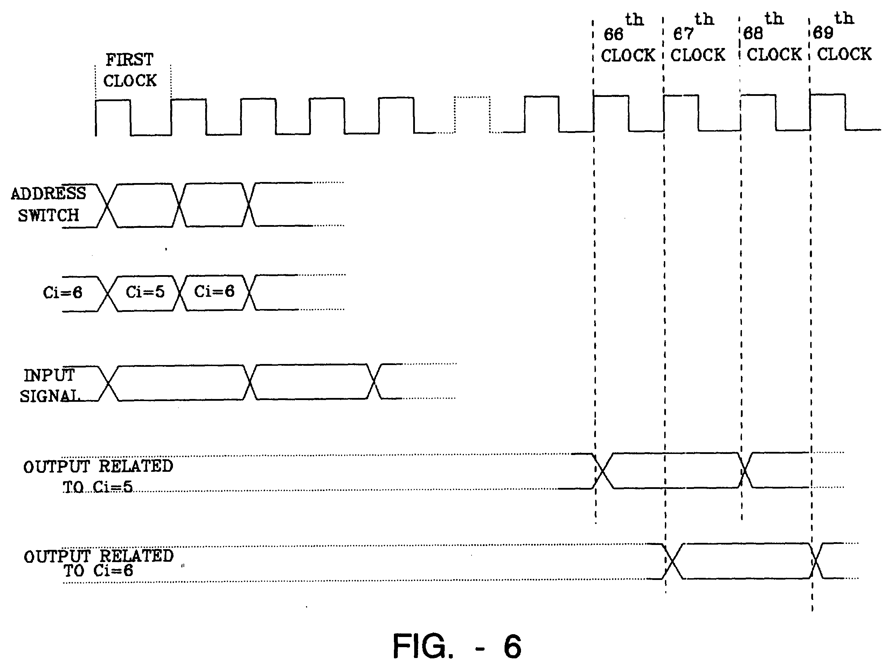

- Figure 6 shows the control signal patterns of the filtering arrangement according to the invention.
- Figure 7 is a schematic representation of a filter architecture related to that of the invention.

### Detailed Description

With reference to the drawing figures, generally and schematically shown at 1 is a digital filter architecture embodying this invention and being effective to filter digital signals having a high dynamic range using a narrow band filter 2.

In essence, this architecture 1 is adapted to operate with digital signals S which are encoded with at least 7 bits.

The architecture 1 comprises a predetermined number of programmable digital filters, denoted by the acronym PFP.

Such filters 2 have a structure known per se and described, for example, in Italian Patent Application No. 22954-A/88 by this Applicant.

Each filter 2 receives as input a given sampled signal x(n) and outputs another sampled signal having predetermined frequency response characteristics.

The filter 2 is a so-called linear phase FIR (Finite Impulse Response) type, which means that, at each discrete time instant, the input signal x(n) and the output signal y(n) will be tied by the following relation: 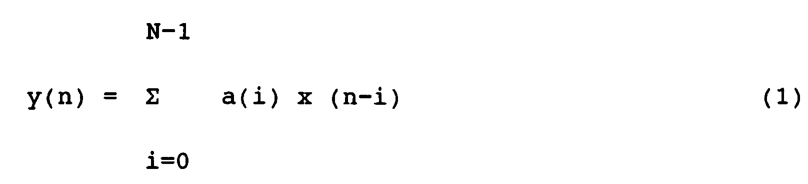 from which it is evinced that the output sample y(n) is only dependent on the present and past input samples.

The coefficients a(i) are finite in number N and are obtainable from the response to the filter pulse.

Furthermore, the filter 2 may be identified by a so-called transfer function H(z), expressed as a function of a complex variable z and defined as the ratio H(z) of the transform Z of a sequence of output sampled signals y(nT) to the transform Z of a sequence of input sampled signals x(nT).

The synthesis at circuit level of that transfer function practically enables implementation of the filter 2 as a single PFP integrated circuit, whereby for each digital input x(n), a y(n) output given by equation (1) would be produced.

The signal inputs to the filter 2 are designated A0,...,A7, whilst the digital outputs are designated O0,...,O15.

Advantageously, the architecture 1 includes a number of filters 2 given by:${\text{m = 2}}^{\text{(d-n+1)}}$ where, d is the number of bits in the input signal, and n is the number of input bits to the filter 2.

To exemplify this invention, reference will be made to a presently preferred, but not limitative, embodiment of the filter 2, it being understood that changes may be made thereto which could still better outline the features of the present method.

The architecture of this invention utilizes the capability of each filter 2 to handle a digital signal quantized in accordance with different transfer functions to be selected by means of a signal applied to an input C of the filter 2.

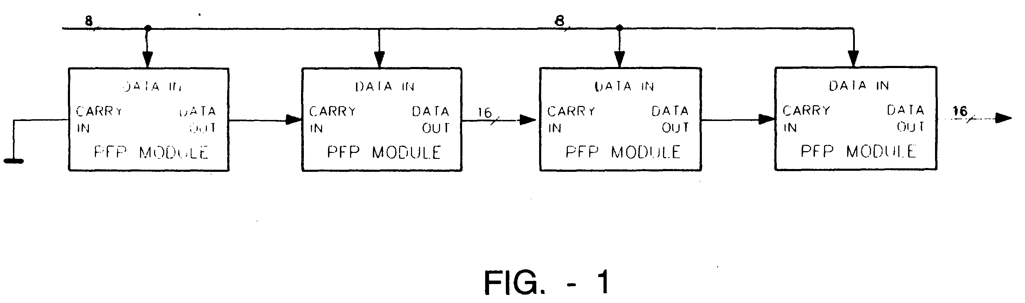

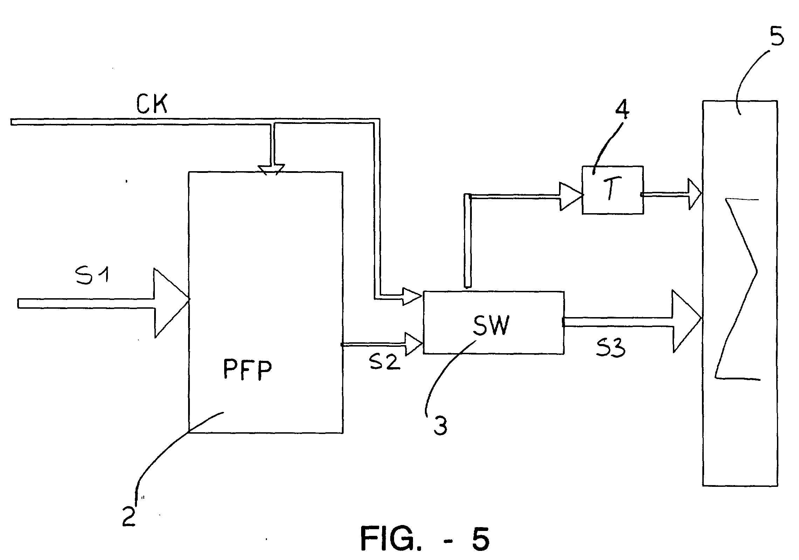

In the embodiment shown in Figure 5, seven-bit input signals are considered: it is evinced from formula (2) that a single filter 2 is required, whereas four are needed in the prior art of Figure 1.

The signal S1 is applied to the inputs A0-A6 of the filter 2.

The filter 2 outputs a 16-bit signal S2 which is addressed to the input side of a switch (SW) 3.

The characteristic of the signal S2, deriving directly from the features of the filter 2 in its present embodiment, consists of alternatively representing the transform provided by the filtering selection I (type 6, that is, signal c=5) and the transform provided by filtering selection II (type 7, that is, signal c=6), of the programmable filter 2.

The output signal S2 can be represented by the following formulae:

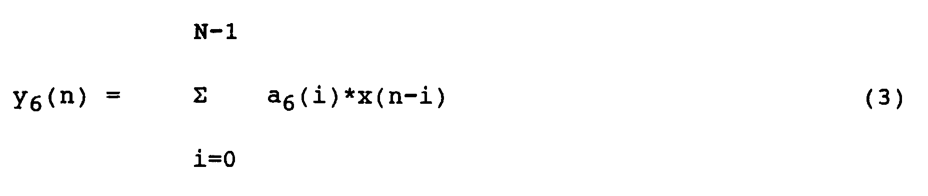

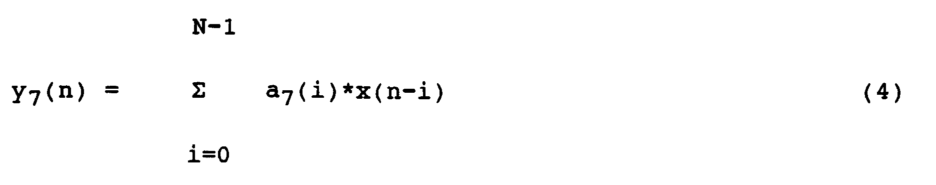

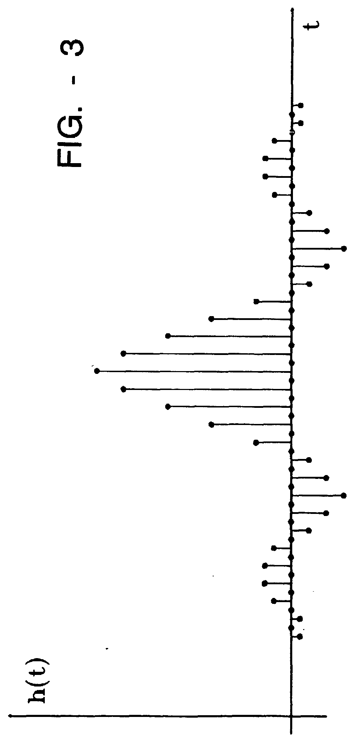

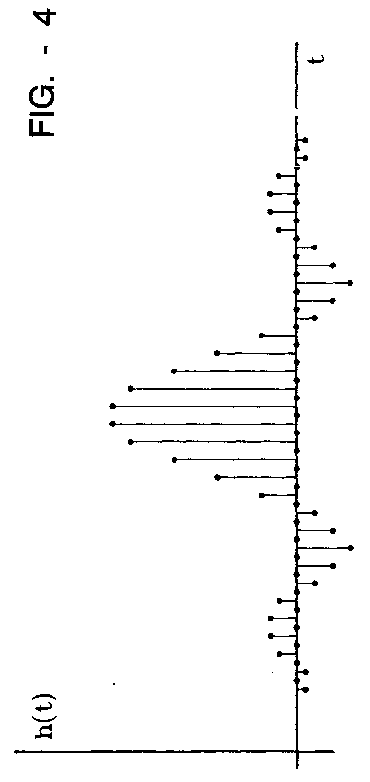

Furthermore, the significant values of the transforms alternate with null coefficients, whereby the response of the filter 2 will take an appearance like that of Figures 3 and 4, respectively.

The switch 3 is assigned the task of addressing the signal S2 alternatively to the adder 5 and the delay block 4.

The latter introduces a time delay equal to the time required by the filter 2 to process the signal by either of the two transfer functions I and II (type 6 and type 7).

Thus, the adder 5 is assigned the task of reconstituting the final signal by summing together the signals S2 as generated from the signal S1 itself and transformed by the filtering functions I and II, respectively.

A clock signal CK is used both for switching filtering mode (alternatively, from ci=5 to ci=6) and driving the switch 3.

The output signal S3 from 5 will represent the filter overall transfer function as (5) hereinbelow: 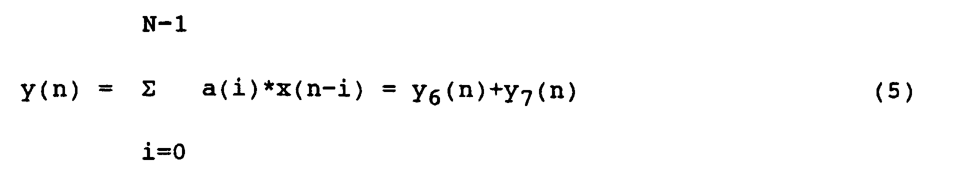 with a number of significant values equal to the sum of the significant values of each of the two transfer functions.

In the example being considered, for a symmetric signal processed by means of the present embodiment of the filter 2, 63 significant values can be obtained using a single filter 2.

Notice that it would normally allow the generation of no more than 32 coefficients (type 6, ci=5 ==> 31; type 7, ci=6 ==> 32).

As in the example of Figure 1 an input signal S1 having a seven-bit coding has been selected, it derives according to formula (1), that one filter 2 only needs to be employed.

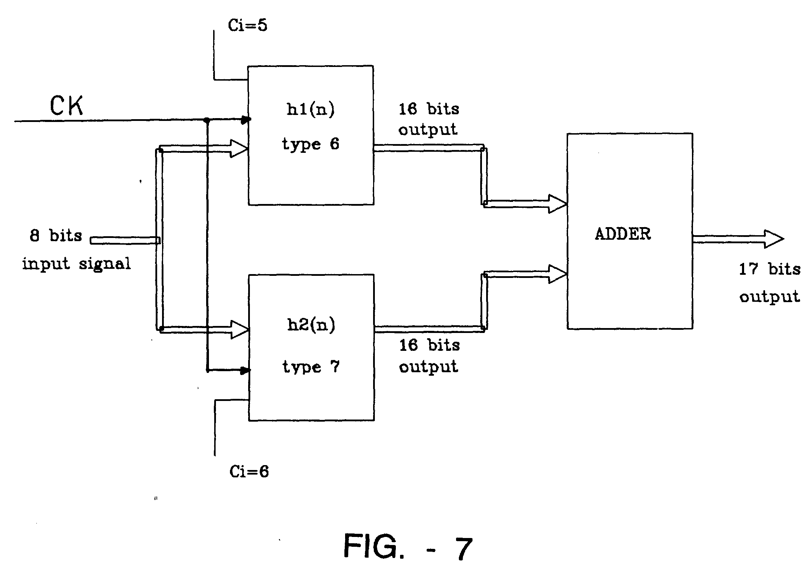

For further illustration, the example of related art shown in Figure 7, wherein the input signal is an 8 bits one,will now be discussed.

From formula (2) above, it may be deduced that two filters 2 are required here, as against four as required by the prior art shown in Figure 1.

More particularly, the structure depicted in Figure 7 is a simplification of Figure 5, wherein the switch 3 and delay line 4 can be omitted on account of the special functionality of the filter 2 being tied to the timing of the output signal S2.

Also brought forth is the fact that the signal CK is no longer used for switching between filtering modes (from I to II, or from type 6 to type 7), as the first filter 2 constantly operates in the filtering I mode (type 6, ci=5) and the second filter 2 is constantly selected for filtering in the II mode (type 7, ci=6).

The architecture and method described in the foregoing are especially advantageous where the input signal S is encoded with seven bits.

In that case,in fact, a single PFP filter would be sufficient to provide a high degree of accuracy in filtering within a very short time.

Of course, an increased dynamic range for the input signal would burden the circuit with added complexity; it should not be overlooked, however, that the integrated circuits which comprise the filters 2 are available at a fairly low price.

Thus, the method of this invention has a major advantage in that it allows the use of plural integrated PFP filters, of well-proven reliability, as against alternative approaches which are much more costly at both design and production level.

## Claims

1. A method of filtering an input digital signal having high dynamic ranges to obtain an output signal, comprising the steps of:
a first step of filtering the input signal (S1) using a first filtering operation to provide a first filtered signal;
a second step of filtering the input digital signal using a second filtering operation to provide a second filtered signal; and
summing the first and second filtered signals from each filtering operation to provide the output digital signal (S2);
characterized in that the first and second filtering steps are performed using a single programmable filter (2) and that the first and second filtered signals are presented at the outputs of the programmable filter alternately in time division according to a clock signal (CK).

2. A method according to Claim 1, characterized in that null values are inserted between the significant samples of the response to the pulse.

3. A method according to Claim 1, characterized in that the program filter (2) memory contains the resultant products of all the input values possible by the coefficients related to the response to the pulse for each of the filtering modes provided.

4. A method according to Claim 1, characterized in that the signals filtered during the various filtering operations are summed together, following appropriate phasing, to provide the overall result of the filter global filtering action.

5. A high-resolution digital filter architecture for filtering an input digital signal to obtain an output digital signal, of a type which comprises:
- a programmable digital filter (2) having first and second alternatively selectable filtering modes, an input to receive the input digital signal and an output which provides an output signal;
- at least one storage structure in said programmable digital filter receiving as input a sampled digital signal (S1) for converting the input signal into an output signal (S2) having predetermined frequency response characteristics;
- characterized in that it further comprises:
- means (C) for causing the programmable digital filter (2), having as input the input digital signal, to provide as output a first and a second filtered signal according to a first and a second filtering mode selected by a clock signal (CK);
- a switch (3) controlled by the clock signal (CK) for directing a first filtered signal to a first output and a second filtered signal to a second output;
- a delay block (4) for delaying the first filtered signal;
- an adder (5) having a first and a second input for receiving the first and second filtered signals and adding such signals to obtain the output digital signal.

6. An architecture according to Claim 5, characterized in that the storage structure is a look-up table containing the products of all the input values possible by the coefficients related to the response to the input pulse for each filtering mode and being addressed cyclically in accordance with a selected filtering sequence.

7. An architecture according to Claim 5, characterized in that the rate of the control signal and the addressing into storage is n times the input signal rate, where n is the number of the filtering operations to be performed by one and the same program filter.

## Patentansprüche

1. Verfahren zum Filtern eines digitalen Eingangssignals mit hohem dynamischen Bereich, um ein Ausgangssignal zu erhalten, umfassend die Schritte:
einen ersten Schritt des Filterns des Eingangssignals (S1) mit einer ersten Filteroperation, um ein erstes gefiltertes Signal zu erhalten;
einen zweiten Schritt des Filterns des eingegebenen digitalen Signals unter Verwendung einer zweiten Filteroperation, um ein zweites gefiltertes Signal zu erhalten; und
Summieren des ersten und des zweiten gefilterten Signals aus der jeweiligen Filteroperation, um das digitale Ausgangssignal (S2) zu erhalten;
**dadurch gekennzeichnet**,
daß der erste und der zweite Filterschritt unter Verwendung eines einzigen programmierbaren Filters (2) durchgeführt werden, und
daß das erste und das zweite gefilterte Signal an den Ausgängen des programmierbaren Filters abwechselnd im Zeitmultiplex entsprechend einem Taktsignal (CK) bereitgestellt werden.

2. Verfahren nach Anspruch 1,
**dadurch gekennzeichnet,**
daß zwischen signifikante Abtastungen der Impulsantwort Nullwerte eingefügt werden.

3. Verfahren nach Anspruch 1,
**dadurch gekennzeichnet,**
daß das Programmfilter (2) als Speicher die Ergebnisprodukte sämtlicher möglicher Eingangswerte in Form der Koeffizienten beinhaltet, welche sich auf die Impulsantwort für jede der möglichen Filterungsarten beziehen.

4. Verfahren nach Anspruch 1,
**dadurch gekennzeichnet,**
daß die während der verschiedenen Filteroperationen gefilterten Signale nach geeigneter Phasenanpassung aufsummiert werden, um das Gesamtergebnis der globalen Filterwirkung bereitzustellen.

5. Digitaler Filteraufbau hoher Auflösung zum Filtern eines digitalen Eingangssignals, um ein digitales Ausgangssignal zu erhalten, wobei der Filtertyp aufweist:
- ein programmierbares Digitalfilter (2) mit einer ersten und einer zweiten, abwechselnd auswählbarer Filterbetriebsart, mit einem Eingang zum Empfangen des digitalen Eingangssignals, und mit einem Ausgang, der ein Ausgangssignal bereitstellt;
- mindestens eine Speicherstruktur innerhalb des programmierbaren Digitalfilters, die als Eingangsgröße ein abgetastetes digitales Signal (S1) zum Umwandeln des Eingangssignals in ein Ausgangssignal (S2) aufweist, wobei das Ausgangssignal einen vorbestimmten Frequenzgang aufweist;
**dadurch gekennzeichnet,**
daß er außerdem aufweist:
- eine Einrichtung (C) zum Veranlassen des programmierbaren Digitalfilters (2), dem als Eingangsgröße das digitale Eingangssignal zugeführt wird, als Ausgangsgröße ein erstes und ein zweites gefiltertes Signal entsprechend einer ersten bzw. einer zweiten Filterungsbetriebsart, die durch ein Taktsignal (CK) ausgewählt wird, bereitzustellen;
- einen Schalter (3), der von dem Taktsignal (CK) gesteuert wird, um ein erstes gefiltertes Signal einem ersten Ausgang zuzuführen, und um ein zweites gefiltertes Signal einem zweiten Ausgang zuzuführen;
- einen Verzögerungsblock (4) zum Verzögern des ersten gefilterten Signals;
- einen Addierer (5) mit einem ersten und einem zweiten Eingang zum Empfangen des ersten und des zweiten gefilterten Signals und zum Addieren dieser Signale, um das digitale Ausgangssignal zu erhalten.

6. Aufbau nach Anspruch 5,
**dadurch gekennzeichnet,**
daß die Speicherstruktur eine Nachschlagetabelle ist, welche die Produkte sämtlicher möglicher Eingangswerte in Form der Koeffizienten enthält, die sich auf die Eingangsimpulsantwort für jede Filterungsbetriebsart bezieht, und die zyklisch gemäß einer ausgewählten Filterungsabfolge adressiert wird.

7. Aufbau nach Anspruch 5,
**dadurch gekennzeichnet,**
daß die Geschwindigkeit des Steuersignals und der Adressierung für den Speicher dem n-fachen der Eingangssignal-Geschwindigkeit entspricht, wobei n die Anzahl der Filterungsoperationen ist, die von ein und demselben Programmfilter auszuführen sind.

## Revendications

1. Un procédé de filtrage d'un signal numérique d'entrée ayant des plages dynamiques élevées pour obtenir un signal de sortie, comprenant les étapes suivantes :
une première étape de filtrage du signal d'entrée (S1) comprenant une première opération de filtrage pour produire un premier signal filtré ;
une seconde étape de filtrage du signal numérique d'entrée comprenant une seconde opération de filtrage pour produire un second signal d'entrée ; et
la sommation des premier et second signaux filtrés issus de chaque opération de filtrage pour produire le signal numérique de sortie (S2);
caractérisé en ce que les première et seconde étapes de filtrage sont effectuées en utilisant un unique filtre programmable (2), et en ce que les premier et second signaux filtrés sont présentés aux sorties du filtre programmable alternativement en temps partagé sur la base d'un signal d'horloge (CK).

2. Un procédé selon la revendication 1, caractérisé en ce que des valeurs nulles sont insérées entre les échantillons significatifs de la réponse à l'impulsion.

3. Un procédé selon la revendication 1, caractérisé en ce que la mémoire du filtre programmable (2) contient les produits résultants de toutes les valeurs d'entrée possibles par les coefficients relatifs à la réponse à l'impulsion pour chacun des modes de filtrage prévus.

4. Un procédé selon la revendication 1, caractérisé en ce que les signaux filtrés pendant les diverses opérations de filtrage sont sommés ensemble, après un accord de phase approprié, pour obtenir le résultat global de l'action de filtrage globale du filtre.

5. Une architecture de filtre numérique à haute résolution pour le filtrage d'un signal numérique d'entrée en vue d'obtenir un signal numérique de sortie, d'un type comprenant :
- un filtre numérique programmable (2) ayant des premier et second modes de filtrage pouvant être sélectionnés alternativement, une entrée pour recevoir le signal numérique d'entrée et une sortie qui délivre un signal de sortie ;
- au moins une structure de stockage dans ledit filtre numérique programmable recevant en entrée un signal numérique échantillonné (S1) pour convertir le signal d'entrée en un signal de sortie (S2) ayant des caractéristiques de réponse en fréquence prédéterminées ;
caractérisée en ce qu'elle comprend en outre :
- un moyen (C) pour faire produire en sortie par ledit filtre numérique programmable (2) ayant reçu en entrée le signal numérique d'entrée, des premier et second signaux filtrés selon des premier et second modes de filtrage sélectionnés par un signal d'horloge (CK) ;
- un commutateur (3) commandé par le signal d'horloge (CK) pour diriger un premier signal filtré vers une première sortie et un second signal filtré vers une seconde sortie ;
- un bloc à retard (4) pour retarder le premier signal filtré ;
- un additionneur (5) ayant des première et seconde entrées pour recevoir les premier et second signaux filtrés et sommer ceux-ci afin d'obtenir le signal numérique de sortie.

6. Une architecture selon la revendication 5, caractérisée en ce que la structure de stockage est une table de consultation contenant les produits de toutes les valeurs d'entrée possibles par les coefficients relatifs à la réponse à l'impulsion d'entrée pour chaque mode de filtrage, et qui est consultée cycliquement en fonction d'une séquence de filtrage sélectionnée.

7. Une architecture selon la revendication 5, caractérisée en ce que la vitesse du signal de commande et de l'adressage en mémoire est n fois la vitesse du signal d'entrée, où n est le nombre d'opérations des opérations de filtrage à effectuer par un même filtre programmable.
